# DEMANDE DE BREVET EUROPEEN

(11) **EP 4 814 620 A1**
(43) Date de publication de la demande: **30.09.2026**
(21) Numéro de dépôt: 25166985.9
(22) Date de dépôt: 28.03.2025
(51) Int. Cl.: G04B 1/14, C23C 16/00, C23C 16/06, G04B 45/00, G04D 3/00

(54) **RESSORT DE BARILLET COLORÉ**

(71) Demandeur: Nivarox-FAR S.A., 2400 Le Locle (CH)
(72) Inventeur: VILLAR, Ivan, 2555 Brügg (CH); KISSLING, Gregory, 2520 La Neuveville (CH); JUILLET, Roger, 2052 Fontainemelon (CH)
(74) Mandataire: ICB SA

(57) **Abrégé**

L'invention se rapporte à un ressort de barillet (1) comprenant un substrat (4) revêtu avec une couche (2) d'Al₂O₃ et/ou avec une couche (3) de TiO₂ avec une épaisseur totale pour l'ensemble des couches inférieure ou égale à 125 nm afin d'obtenir une couleur par effet interférentiel.

## Description

### Domaine technique de l'invention

La présente invention se rapporte à un ressort de barillet coloré et en particulier à un ressort de barillet de couleur bleue.

### Arrière-plan technologique

Les lames de ressort de barillet sont historiquement fabriquées en acier au carbone, en acier type maraging, en acier austénitique inoxydable type 1.4310 ou en alliage austénitique à base cobalt type Nivaflex. Ces matériaux présentent une couleur naturelle grise métallique qui n'est en général pas modifiée par le fabriquant de ressorts ou de barillets complets.

Il est probable que des ressorts en acier au carbone bleuis thermiquement ont été produits dans le passé. Le bleuissement thermique fonctionne mal pour des aciers austénitiques ou pour les alliages austénitiques à base cobalt en raison de leur bonne résistance à l'oxydation.

### Résumé de l'invention

La présente invention a pour objet de pallier ces inconvénients en proposant un ressort de barillet avec une coloration de type interférentiel.

Pour ce faire, il est proposé de déposer une couche d'Al₂O₃ et/ou une couche de TiO₂ dans une gamme d'épaisseur donnée pour obtenir une couleur interférentielle et en particulier une couleur bleue.

Avantageusement, le ressort de barillet est revêtu successivement avec une couche d'Al₂O₃ et une couche de TiO₂, la couche extérieure de TiO₂ ayant pour avantage d'être plus résistante à l'humidité tandis que le procédé de dépôt de la couche intérieure d'Al₂O₃ a pour avantage d'être hautement reproductible.

Le ressort de barillet obtenu présente une couleur bleue très soutenue, conforme et homogène malgré la géométrie complexe d'un ressort de barillet. Selon l'invention, cette couleur bleue soutenue et homogène peut être obtenue sans nécessiter de dépôt d'une sous-couche sur le matériau de base du substrat formant le ressort de barillet. Ainsi, la couche de TiO₂ ou d'Al₂O₃ est en contact direct avec la surface du ressort de barillet.

En outre, cette couche interférentielle permet d'améliorer la tenue à l'usure du ressort de barillet en réduisant le frottement entre les spires.

### Brève description des figures

La figure 1 représente un ressort de barillet.
La figure 2 représente schématiquement avec une vue en coupe la couche interférentielle sur le ressort de barillet selon une variante de l'invention.
La figure 3 représente schématiquement avec une vue en coupe les deux couches interférentielles sur le ressort de barillet selon une autre variante de l'invention.

### Description détaillée de l'invention

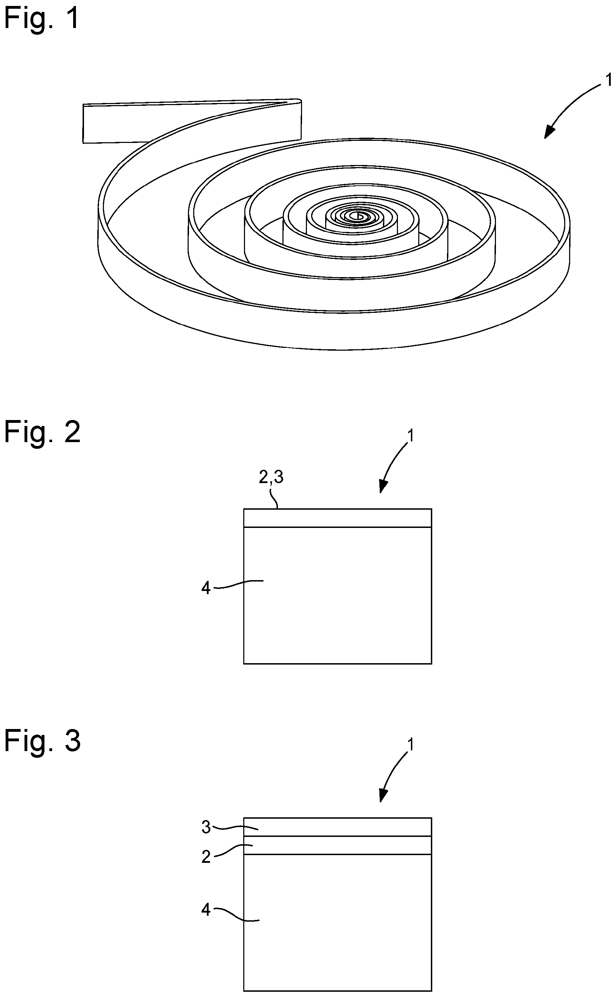

Tel que représenté aux figures 1 à 3, la présente invention se rapporte à un ressort de barillet 1 comportant un substrat 4 revêtu avec une couche 2 d'Al₂O₃ et/ou avec une couche 3 de TiO₂ avec pour l'ensemble des couches une épaisseur inférieure ou égale à 125 nm afin d'obtenir un effet interférentiel. En présence d'une couche d'Al₂O₃ et d'une couche de TiO₂, le substrat est de préférence revêtu successivement avec une première couche 2 d'Al₂O₃ et avec une deuxième couche 3 de TiO₂. Selon l'invention, chacune des couches est avantageusement déposée par ALD (*Atomic Layer Deposition*)*.* De préférence, la couche de TiO₂ ou d'Al₂O₃ est en contact direct avec la surface du substrat. Bien que non limitatif, le matériau du substrat est plus spécifiquement un acier au carbone, un acier type maraging, un acier austénitique inoxydable par exemple type 1.4310 ou un alliage austénitique à base cobalt par exemple type Nivaflex^{®}.

En présence d'une seule couche sur le substrat 4 selon la variante de la figure 2, la couche 3 de TiO₂ a une épaisseur comprise entre 30 et 70 nm, de préférence entre 35 et 55 nm, plus préférentiellement entre 40 et 52 nm, encore plus préférentiellement entre 48 et 52 nm pour obtenir une couleur bleue soutenue. De manière particulièrement préférée, la couche de TiO₂ a une épaisseur de 50 nm.

En présence d'une seule couche sur le substrat 4 selon la variante de la figure 2, la couche 2 d'Al₂O₃ a une épaisseur comprise entre 75 et 125 nm, de préférence entre 90 et 110 nm, plus préférentiellement entre 95 et 105 nm, encore plus préférentiellement entre 98 et 102 nm pour obtenir une couleur bleue soutenue. De manière particulièrement préférée, la couche d'Al₂O₃ a une épaisseur de 100 nm.

En présence d'une première couche 2 d'Al₂O₃ et d'une deuxième couche 3 de TiO₂ selon la variante de la figure 3, la première couche d'Al₂O₃ a une épaisseur comprise entre 10 et 50 nm et la deuxième couche de TiO₂ a une épaisseur comprise entre 10 et 45 nm. De préférence, la première couche d'Al₂O₃ a une épaisseur comprise entre 30 et 40 nm et la deuxième couche de TiO₂ a une épaisseur comprise entre 20 et 40 nm. Plus préférentiellement, la première couche d'Al₂O₃ a une épaisseur comprise entre 32 et 38 nm et la deuxième couche de TiO₂ a une épaisseur comprise entre 25 et 35 nm. De manière particulièrement préférée, la couche d'Al₂O₃ a une épaisseur de 35 nm et la couche de TiO₂ a une épaisseur de 28 nm.

On précisera que l'analyse de la composition chimique de la ou des couche(s) peut être réalisée par EDX (*Energy Dispersive X-ray Spectrometer*) tandis que l'épaisseur de la ou des couche(s) peut être mesurée par ellipsométrie.

## Revendications

1. Ressort de barillet (1) comprenant un substrat (4) revêtu avec une couche (2) d'Al2O3 et/ou avec une couche (3) de TiO2 avec une épaisseur totale pour l'ensemble des couches inférieure ou égale à 125 nm afin d'obtenir une couleur par effet interférentiel.

2. Ressort de barillet (1) selon la revendication 1, pour lequel le substrat (4) est revêtu avec une couche (2) d'Al₂O₃ ayant une épaisseur comprise entre 75 et 125 nm.

3. Ressort de barillet (1) selon la revendication 2, pour lequel la couche (2) d'Al₂O₃ a une épaisseur comprise entre 90 et 110 nm.

4. Ressort de barillet (1) selon la revendication 2 ou 3, pour lequel la couche (2) d'Al₂O₃ a une épaisseur comprise entre 95 et 105 nm.

5. Ressort de barillet (1) selon l'une des revendications 2 à 4, pour lequel la couche (2) d'Al₂O₃ a une épaisseur comprise entre 98 et 102 nm.

6. Ressort de barillet (1) selon la revendication 1, pour lequel le substrat (4) est revêtu avec une couche (3) de TiO₂ ayant une épaisseur comprise entre 30 et 70 nm.

7. Ressort de barillet (1) selon la revendication 6, pour lequel la couche (3) de TiO₂ a une épaisseur comprise entre 35 et 55 nm.

8. Ressort de barillet (1) selon la revendication 6 ou 7, pour lequel la couche (3) de TiO₂ a une épaisseur comprise entre 40 et 52 nm.

9. Ressort de barillet (1) selon l'une des revendications 6 à 8, pour lequel la couche (3) de TiO₂ a une épaisseur comprise entre 48 et 52 nm.

10. Ressort de barillet (1) selon la revendication 1, pour lequel le substrat (4) est revêtu successivement avec une couche (2) d'Al₂O₃ et avec une couche (3) de TiO₂, ladite couche (2) d'Al₂O₃ ayant une épaisseur comprise entre 10 et 50 nm et ladite couche (3) de TiO₂ ayant une épaisseur comprise entre 10 et 45 nm.

11. Ressort de barillet (1) selon la revendication 10, pour lequel ladite couche (2) d'Al₂O₃ a une épaisseur comprise entre 30 et 40 nm et ladite couche (3) de TiO₂ a une épaisseur comprise entre 20 et 40 nm.

12. Ressort de barillet (1) selon la revendication 10 ou 11, pour lequel ladite couche (2) d'Al₂O₃ a une épaisseur comprise entre 32 et 38 nm et ladite couche (3) de TiO₂ a une épaisseur comprise entre 25 et 35 nm.

13. Ressort de barillet (1) selon l'une des revendications précédentes, pour lequel le substrat (4) est réalisé dans un acier au carbone, dans un acier type maraging, dans un acier austénitique inoxydable ou dans un alliage austénitique à base cobalt.

14. Ressort de barillet (1) selon l'une des revendications précédentes, pour lequel ladite couche (2) d'Al₂O₃ ou ladite couche (3) de TiO₂ est en contact direct avec la surface du substrat (4).
